# EUROPEAN PATENT APPLICATION

(11) **EP 4 120 369 A1**
(43) Date of publication of application: **18.01.2023**
(21) Application number: 21818222.8
(22) Date of filing: 30.04.2021
(51) Int. Cl.: H01L 31/05

(54) **RIBBON AND SOLAR CELL ASSEMBLY**

(30) Priority: 05.06.2020 CN 202021026993 U
(71) Applicant: Risen Energy (Yiwu) Co., Ltd., Yiwu, Zhejiang 322000 (CN)
(72) Inventor: HUANG, Qiang, Zhejiang 322000 (CN); HUANG, Rubin, Zhejiang 322000 (CN)
(74) Representative: Baldus, Oliver
(86) International application number: PCT/CN2021/091603
(87) International publication number: WO 2021/244200

(57) **Abstract**

Provided are a ribbon (200) and a solar cell assembly, relating to the technical field of solar cells. The welding ribbon (200) comprises a composite core (220) and a surface coating layer (210) wrapped around said composite core (220); the composite core (220) comprises a plurality of welding cores (230), at least one first bending part (221) is provided on each of said welding cores (230), and the plurality of welding cores (230) are wound with each other by means of the respective first bending parts (221) to form the composite core (220); in addition, at least one third bending part (260) is also provided on the welding ribbon (200), at least one of the third bending parts (260) is closely attached to the middle part of the corresponding battery sheet (300), and the direction of bending of the third bending part (260) is perpendicular to the length direction of the welding core (230). The first bending part (221) on each welding core (230) in the composite core (220) and/or the at least one third bending part (260) on the welding ribbon (200) buffer the stress between the welding ribbon (200) and the battery sheet (300), reducing the occurrence of fragmentation or the probability of cracks forming in the battery sheet (300), thus improving yield, and also helping to improve the power generation and reliability of the solar cell assembly.

## Description

### CROSS-REFERENCE TO RELATED APPLICATIONS

The present disclosure claims the priority of a Chinese patent application filed with the China Patent Office on June 5, 2020, with application number 202021026993.7 and entitled "Ribbon and Solar Cell Assembly", the entire contents of which are incorporated herein by reference.

### Technical Field

The present disclosure relates to the technical field of solar cells, and in particular, to a welding ribbon and a solar cell assembly.

### Background Art

With development of photovoltaic technology, the pursuit in this industry for high power and low cost is almost extreme. The battery module technology related to ultra-large ultra-thin silicon wafers has become the key technology for promoting the development of the industry. On one hand, for pursuing the throughput cost advantage in production, the area of a single silicon wafer is getting larger and larger, with the side length rapidly expanding from 125 mm to 166 mm and 210 mm. On the other hand, in order to reduce the cost of a single battery sheet, the thickness of a single silicon wafer is getting thinner and thinner, with the thickness rapidly expanding from 200 um to 175 um (backside passivation PERC cell technology), and even 130 um (heterojunction HJT cell technology). Ultra-large ultra-thin silicon wafers (such as, the silicon wafers with the side length of 210 mm and the thickness of 130 um) bring the unprecedented challenges to the manufacture of photovoltaic cells, especially the manufacture of photovoltaic modules. One of the biggest challenges in the manufacture of ultra-large ultra-thin cells is to avoid the yield problems, such as, debris and cracks during the welding and interconnection process of battery sheets.

In the prior art, during the welding and interconnection process of the battery sheets, the battery sheets, with metal gate lines on the front surface and the back surface, all achieve the front-surface-interconnection through the welding ribbon, so as to realize the series connection between the battery sheets.

However, due to the different materials of the welding ribbon and the battery sheet, the welding ribbon and the battery sheet have different thermal expansion coefficients, so that there will be strong stress between the welding ribbon and the battery sheet, resulting in that it is easy to produce the yield problems, and the situations arise that debris appears or the battery sheet is cracked therein.

Patent document CN202473995U provides a solar assembly welding ribbon. A bending structure is provided on the welding ribbon, and the bending structure is located at the position of the welding ribbon at which it is welded with the edge of the battery sheet. However, in the way that the welding ribbon is bent at the edge of the battery sheet, the reduced value of the length of the effective material of the welding ribbon is relatively small, and the effect on the length variation of the welding ribbon is relatively small, so that it cannot effectively solve the stress problem between the welding ribbon and the battery sheet.

Patent document CN103972317A provides an interconnection bar for solar cells, which comprises a metal base material including a plurality of interwoven metal wires formed by weaving. However, these woven metal wires affect the light-receiving area of the cell surface on the surface of the battery sheet, and the fabrication steps of the woven pattern are complicated and difficult to control.

### Summary

An object of the present disclosure is at least to provide a welding ribbon and a solar cell assembly, which can buffer the stress between the welding ribbon and the battery sheet, and reduce the probability that debris appears or the battery sheet is cracked therein.

Embodiments of the present disclosure are implemented as follows.

An embodiment of the present disclosure proposes a welding ribbon, which comprises a composite core and a coating (surface coating layer) wrapped around the composite core. The composite core comprises a plurality of welding cores, and each of the welding cores is provided with at least one first bending part, the plurality of the welding cores are wound with each other through the respective first bending parts to form the composite core.

In one embodiment, the plurality of the welding cores are divided into a plurality of welding core groups, and each of the welding core groups comprises one or more welding cores, and the plurality of the welding core groups are wound with each other to form the composite core.

In one embodiment, each of the welding core groups comprises a plurality of the welding cores; and in each of the welding core groups, the plurality of welding cores are arranged side by side or the plurality of the welding cores are wound with each other.

In one embodiment, two welding core groups are provided, and the two welding core groups are wound with each other to form the composite core in shape of a thread, a twisted pair, or a sailor knot.

In one embodiment, three welding core groups are provided, and the three welding core groups are wound with each other to form the composite core in shape of a braid.

In one embodiment, a bending direction of the first bending part is arranged as inclined relative to or as perpendicular to a length direction of the welding cores.

In one embodiment, a radial cross section of the welding core is circular, elliptical, rectangular, square, trapezoidal or triangular.

In one embodiment, the welding ribbon is formed in a way that the composite welding core, after being subjected to a high temperature annealing treatment, is wrapped with the coating;

In one embodiment, the material of the coating is tin, bismuth, lead, indium, tin alloy, bismuth alloy, lead alloy or indium alloy; and preferably the coating is formed by electroplating or hot dipping.

In one embodiment, the material of the welding cores is copper or steel.

In one embodiment, individual welding cores have same lengths and same diameters.

The embodiment of the present disclosure also provides a welding ribbon, comprising: a single welding core and a coating wrapped around the single welding core; and at least one third bending part, which is provided on the welding ribbon, wherein a bending direction of the third bending part is arranged as perpendicular to a length direction of the single welding core.

In one embodiment, a bending direction of the third bending part is parallel to a surface of a corresponding battery sheet; and preferably, the third bending part is of a structure which is one of following: a circular structure, a triangular structure, a trapezoidal structure, a square structure or a wave-shaped structure.

The embodiment of the present disclosure also proposes a solar cell assembly, comprising: a plurality of welding ribbons and a plurality of battery sheets, wherein the plurality of battery sheets are connected by the plurality of the welding ribbons, and the plurality of welding ribbons are those mentioned above, wherein each of the welding ribbons is provided with at least one second bending part, and the second bending part is provided between two adjacent battery sheets; a bending direction of the second bending part is a thickness direction of the battery sheets.

In one embodiment, each of the welding ribbons is provided with at least one third bending part, and the at least one third bending parts is closely attached to a middle portion of a corresponding battery sheet, and a bending direction of the third bending part is arranged as perpendicular to a length direction of the welding cores; preferably, a bending direction of the third bending part is parallel to a surface of a corresponding battery sheet; and preferably, the third bending part is of a structure which is one of following: a circular structure, a triangular structure, a trapezoidal structure, a square structure or a wave-shaped structure.

In one embodiment, the solar cell assembly comprises: a plurality of reinforcing blocks, which are arranged on gate lines of the battery sheet, wherein the welding ribbon is arranged on the gate line of the corresponding battery sheet, and each of the third bending parts is located between two adjacent reinforcing blocks; preferably, the gate lines are in number of 9, 10 or 12; preferably, the reinforcing blocks are evenly distributed on the gate lines and intervals between adjacent third bending parts are equal; and preferably, on each of the gate lines of the corresponding battery sheet, the reinforcing blocks are in number of 5.

The embodiment of the present disclosure proposes a solar cell assembly, comprising: a plurality of welding ribbons and a plurality of battery sheets. The plurality of battery sheets are connected through the plurality of welding ribbons. Each of the welding ribbons comprises a welding core and a coating wrapped around the welding core, wherein each of the welding ribbons is provided with at least one second bending part and at least one third bending part, and the second bending part is provided between two adjacent battery sheets, and the third bending part is tightly attached to a middle portion of the corresponding battery sheet; and a bending direction of the second bending part is a thickness direction of the battery sheet, and a bending direction of the third bending part is arranged as perpendicular to a length direction of the welding core.

In one embodiment, the welding core is a single welding core; preferably, the welding core is of a cylindrical linear structure; and preferably, the welding core is a round thin copper wire of 0.25 mm to 0.35 mm.

In one embodiment, a bending direction of the third bending part is parallel to a surface of the corresponding battery sheet; and preferably, the third bending part is of a structure which is one of following: a circular structure, a triangular structure, a trapezoidal structure, a square structure or a wave-shaped structure.

In one embodiment, the welding core is a single welding core; the plurality of the welding ribbons form a composite welding ribbon by being would with each other through respective third bending parts; and preferably, the composite welding ribbon is one of a thread shape, a twisted pair shape, a sailor knot shape, a braid shape, or a Chinese knot shape.

In one embodiment, the solar cell assembly comprises a plurality of reinforcing blocks, which are arranged on the gate lines of the battery sheet, wherein the welding ribbon is arranged on the gate line of the corresponding battery sheet, and each of the third bending parts is located between two adjacent reinforcing blocks; preferably, the gate lines are in number of 9, 10 or 12; preferably, the reinforcing blocks are evenly distributed on the gate line and intervals between adjacent third bending parts are equal; and preferably, on each gate line of the corresponding battery sheet, the reinforcing blocks are in number of 5.

The beneficial effects of the present disclosure compared with the prior art comprise, for example, the follows.

In the embodiments of the present disclosure, the stress between the welding ribbon and the battery sheet is buffered by the first bending part on each welding core in the composite core, thereby reducing the probability that debris appears or the battery sheet is cracked therein, which can improve the yield rate, and also help to improve the power generation and reliability of solar cell assemblies.

In the embodiment of the present disclosure, the stress between the welding ribbon and the battery sheet is buffered by the third bending part additionally provided on the welding ribbon, so as to reduce the probability of the occurrence of debris or the formation of cracks within the battery sheet, which can improve the yield rate and also help to improve the power generation and reliability of solar cell assemblies.

### Brief Description of Drawings

The drawings are included to provide a further understanding on the embodiments and are incorporated into and constitute a part of this specification. In order to illustrate the technical solutions of the embodiments of the present disclosure more clearly, the drawings needed to be used in the embodiments will be briefly introduced below. It should be understood that the following drawings only show some, but not all, of the embodiments of the present disclosure, and therefore should not be regarded as limiting the scope. For those skilled in the art, other related drawings can also be obtained from these drawings without creative efforts.
FIG. 1 is a schematic diagram of the interconnection of a 9-busbar (9BB) half-piece battery in the related art;
FIG. 2 is the schematic structural diagram of the tin-coated copper tape in FIG.1;
FIG. 3 is a schematic structural diagram of a solar cell assembly according to an embodiment of the present disclosure;
FIG. 4 is a schematic structural diagram of a solar cell assembly according to an embodiment of the present disclosure;
FIG. 5 is a schematic structural diagram of a welding ribbon according to an embodiment of the present disclosure;
FIG. 6 is a schematic structural diagram of a composite core according to an embodiment of the present disclosure;
FIG. 7 is a schematic diagram of the internal structure of a welding ribbon according to an embodiment of the present disclosure;
FIG. 8 is a schematic diagram of the internal structure of a welding ribbon according to an embodiment of the present disclosure;
FIG. 9 is a schematic structural diagram of a composite core according to an embodiment of the present disclosure;
FIG. 10 is a schematic structural diagram of a composite core according to an embodiment of the present disclosure;
FIG. 11 is a schematic structural diagram of a solar cell assembly according to an embodiment of the present disclosure;
FIG. 12 is a schematic structural diagram of a welding ribbon according to an embodiment of the present disclosure;
FIG. 13 is a schematic structural diagram of a welding ribbon according to an embodiment of the present disclosure;
FIG. 14 is a schematic structural diagram of a welding ribbon according to an embodiment of the present disclosure;
FIG. 15 is a schematic structural diagram of a welding ribbon according to an embodiment of the present disclosure;
FIG. 16 is a schematic structural diagram of a welding ribbon according to an embodiment of the present disclosure; and
FIG. 17 is a schematic diagram of the partial structure of a solar cell assembly according to an embodiment of the present disclosure.

Reference Numbers: 100-solar cell assembly; 101- half-piece battery sheet; 102-the other half-piece battery sheet; 103-tin-coated copper tape; 104-metal electrode main gate line; 105-welding reinforcing block; 200-welding ribbon; 201-copper core; 202-tin-coated layer; 210-coating; 220-composite core; 221-first bending part; 230-welding core; 241-first welding core group; 242-second welding core group; 243-third welding core group; 240a-interface; 250-second bending part; 251-first section; 252-second section; 253-third section; 260-third bending part; 300-battery sheet; 300a-front surface; 300b-back surface; 310-first battery sheet; 320-second battery sheet; 301-reinforcing block.

### Detailed Description of Embodiments

It should be noted that similar reference numerals and letters refer to similar items in the following figures, so that once an item is defined in one figure, it is not required to further define and explain it in subsequent figures. In addition, the terms, "first", "second", "third", etc., are only used for describing the distinguishing, and do not indicate the sequence numbers, nor can they be construed as indicating or implying importance in relativity.

In the description of the present disclosure, it should be noted that the orientation or position relationships indicated by the terms, "inner", "outer", "left", "right", "upper", "lower", etc., are based on those shown in the drawings, or the orientation or position relationship in which the disclosed product is usually placed in use, which is only for the convenience of describing the present disclosure and simplifying the description, and does not indicate or imply that the device or element referred to must be in the specific orientation, or be configured and operated in the specific orientation, and therefore cannot be construed as limitations on the present disclosure.

In the description of the present disclosure, unless expressly specified and limited otherwise, the terms, "arranged", "installed", "connected with each other" and "connected to" should be interpreted in a broad sense. For example, it may be a fixed connection or a detachable connection, or an integral connection; it can be a mechanical connection or an electrical connection; it can be a direct connection, or an indirect connection through an intermediate medium, or the internal communication between the two components. For those skilled in the art, the specific meanings of the above terms in the present disclosure can be understood in specific situations.

The technical solutions of the present disclosure will be clearly and completely described below with reference to the drawings.

In the manufacturing process of photovoltaic cell assemblies commonly used in the industry, the battery sheets, with the front surface and the back surface having metal gate lines, achieve the front-back-surface interconnection by tin-coated copper ribbons, to realize the series connection between the battery sheets. The metal gate lines on the front and back surfaces here are generally Ag or Al alloys, such as, Ag paste gate lines, Al paste gate lines, AgAI paste gate lines, etc. formed by screen printing and sintering; or Cu alloys, such as, NiCuSn alloy formed by electroplating process.

Tin-coated copper tapes are divided into two types, the flat tin-coated copper tape and the round tin-coated copper tape, wherein the flat tin-coated copper tape is usually a long strip with a width of 1 mm and a thickness of 0.25 mm. The interior of the welding ribbon is a copper tape, with the surface covered with a Sn alloy layer or a SnPb alloy layer with a thickness of about 15 um. The length of the welding ribbon is cut according to the needs. Generally, it is about twice the length of the side of the battery sheets to be welded and interconnected. This welding ribbon is suitable for the interconnection design of the battery sheets with 6 busbars (6BB) or less, which has been basically eliminated in recent years.

At present, the most used busbar technology in the industry is the multi-busbar technology of 9 busbars (9BB), 10 busbars (10BB) or 12 busbars (12BB). A typical welding ribbon is a copper wire of a diameter of about 0.3mm, with the surface covered with a SnPb alloy layer of about 15um. The length of the welding ribbon is cut according to the needs, and it is generally about twice the length of the side length of the battery sheets to be welded and interconnected.

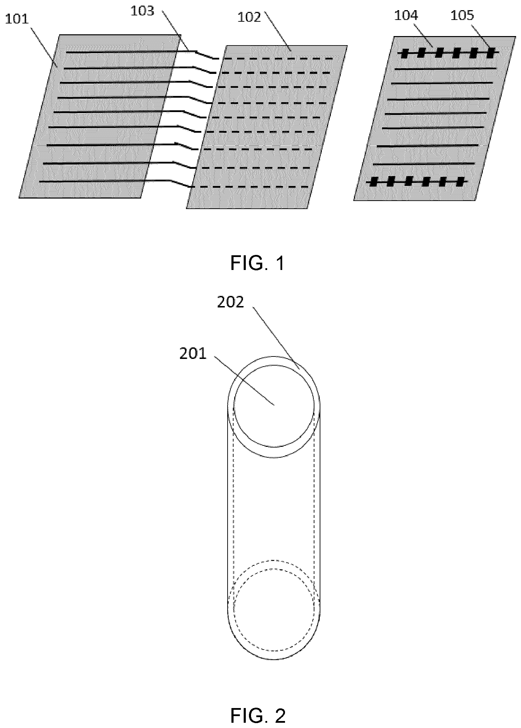

Referring to FIG. 1, it is a schematic diagram of interconnection of a 9-busbar (9BB) half-piece battery in the related art. As shown in FIG. 1, the front surface of the half-piece battery sheet 101 and the back surface of the other half-piece battery sheet 102 are connected to each other by 9 welding ribbons 103 with the surfaces coated with a 15um tin layer. For the convenience of description, the metal electrode main gate line 104 on the surface of the half-piece battery sheet is further shown at the right side of FIG. 1. In order to enhance the welding strength between the tin-coated copper tape 103 and the metal electrode on the battery surface, welding enforcing blocks 105 may also be provided on the main gate line (busbar) of the metal battery. The welding reinforcing blocks 105 can be distributed evenly or unevenly on the 9 metal main gate lines. Generally speaking, as a schematic diagram, only the reinforcing blocks 105 on the outermost main gate line are drawn in FIG. 1.

During the process of producing the assembly, the tin-coated copper tape 103 is placed on the metal electrode main gate line 104 or the welding reinforcing blocks 105 of the battery sheet. The tin-coated copper tape 103 and the metal electrode main gate line 104 or the welding reinforcing blocks 105 are in close contact therebeween, and then they are heated to a high temperature of around 200 °C. At this time, the tin-coated layer on the surface of the tin-coated copper tape 103 is melted, and the tin-coated copper tape 103 and the metal electrode main gate line 104 or the welding reinforcing block 105 are fused to form a benign conductive connection. Therefore, the tin-coated copper tape 103 can effectively enables that the photo-generated current generated by the photovoltaic battery is conducted out.

Referring to FIG. 2, it is a schematic structural diagram of the tin-coated copper tape 103 in FIG. 1. 201 indicates a copper core of tin-coated copper tape, which is usually a round thin copper wire of 0.25 mm to 0.35 mm. The thin copper wire is formed by continuously extruding and thinning the thick copper column or copper stripe by the wire drawing mechanism. In the process of forming the fine copper wire, the copper metal is subjected to strong extrusion stress. Therefore, the stress will be eliminated by the high-temperature heating of the furnace tube or the high-temperature heating of high current and annealing. Then, the copper wire is made to pass through a molten liquid in Sn or Sn alloy to form a surface tin-coated layer 202. The surface tin-coated layer 202 can also be formed by electroplating.

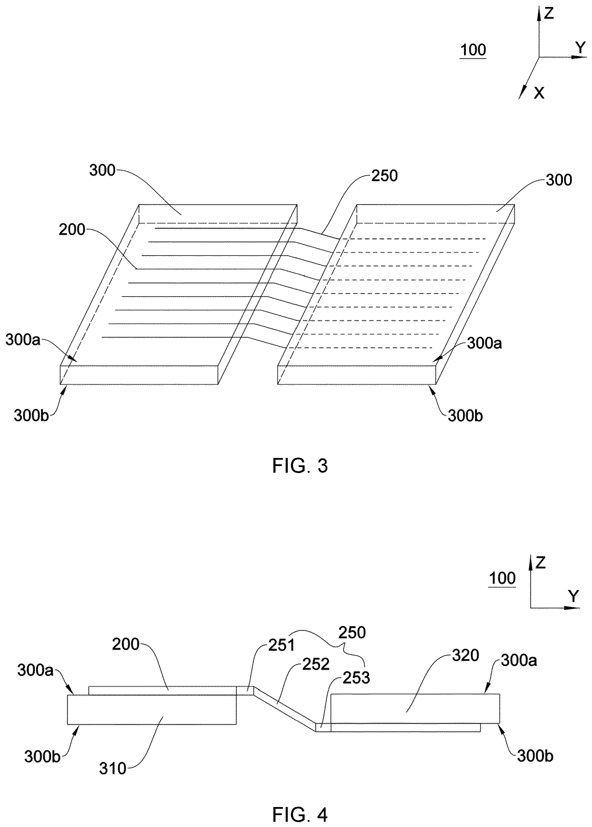

Referring to FIG. 3, it is a schematic structural diagram of a solar cell assembly 100 according to an embodiment of the present disclosure. A solar cell assembly 100 comprises a plurality of welding ribbons 200 and a plurality of battery sheets 300, wherein the plurality of battery sheets 300 are connected by the plurality of the welding ribbons 200. Each welding ribbon 200 is provided with at least one second bending part 250, and the second bending part 250 is disposed between two adjacent battery sheets 300.

The thickness direction of the battery sheet 300 is defined as the Z axis, and the length direction of the welding ribbon 200 is defined as the Y axis. A diameter coordinate system is established to determine the X axis. The positive direction of the Z-axis is called upward, the positive direction of the Y-axis is called rightward, and the positive direction of the X-axis is called forward, so as to define six directions, i.e., the front, back, left, right, upward, and downward directions, wherein the front surface 300a of the battery sheet 300 is the upper surface of the battery sheet 300, and the back surface 300b of the battery sheet 300 is the lower surface of the battery sheet 300. The material of the battery sheet 300 is silicon.

The bending direction of the second bending part 250 is the thickness direction of the battery sheet 300, that is, the Z direction. The second bending part 250 can prevent the welding ribbon 200 from directly contacting the side surface of the battery sheet 300, thereby preventing the problem that during the welding process, the flowing of the tin solder causes the positive and negative electrodes on the front surface 300a of the battery sheet 300 and the back surface 300b of the battery sheet 300 to be connected and communicated (conducted), thereby causing the solar cell assembly 100 to fail.

Herein, the solar cell assembly 100 may be a passivated cell (PERC) battery assembly, a contact passivation (TOPCon) cell assembly, an N-type backside passivation ( N-PERC) cell assembly, an N-type heterojunction (HJT) cell assembly, and a laminated cell battery assembly composed of the above-mentioned batteries.

Referring to FIG. 4, it is a schematic structural diagram of a solar cell assembly 100 shown in an embodiment of the present disclosure. The battery sheet 300 may be a multi-busbar battery sheet. The left battery sheet 300 is referred to as the first battery sheet 310, and the right battery sheet 300 is referred to as the second battery sheet 320. The second bending part 250 may be in a "Z" shape, with a first segment 251, a second segment 252 and a third segment 253 connected to each other. The first segment 251 is in contact with the edge of the front surface 300a of the first battery sheet 310, and the third segment 253 is in contact with the edge of the back surface 300b of the first battery sheet 310. The second bending part 250 is provided with the first segment 251 and the third segment 253, thereby increasing the distance between the second segment 252 and the edge of the adjacent battery sheet 300.

A manufacturing method of a solar cell assembly 100 comprises the following steps:
Step 1: cutting, in half, 72 finished square battery sheets with a side length of 158.75mm designed for 9-busbar (9BB) electrodes, so as to obtain first battery sheets 310 and second battery sheets 320 of the same size;
Step 2: cutting the initial welding ribbon 200 based on an appropriate size, wherein the appropriate size is about twice the side length of the first battery sheet 310;
Step 3: bending the cut welding ribbon 200 of the appropriate size along the Z direction (along the thickness direction of the battery sheet 300 ) through a mechanical extrusion molding mechanism, so as to obtain the welding ribbon 200 with the second bending part 250;
Step 4: placing the first battery sheet 310 on the welding table of the stringer welding machine, and then using a pulling (traction) mechanism to pull the welding ribbon 200 onto the front surface 300a of the first battery sheet 310;
Step 5: placing the second battery sheet 300 on the top of the welding ribbon 200, so that one end of the welding ribbon 200 is connected to the front surface 300a of the first battery sheet 310, and the other end of the welding ribbon 200 is connected to the back surface 300b of the second battery sheet 320, so as to form series connection of the first battery sheet 310 and the second battery sheet 320; and
Step 6: repeating the above processes to complete the series connection of all the battery sheets 300, and then performing the conventional processes, such as typesetting, lamination, and framing, etc., to form the finished solar cell assembly 100.

Herein, Step 3 may be completed before Step 4, or Step 3 and Step 4 may be performed simultaneously.

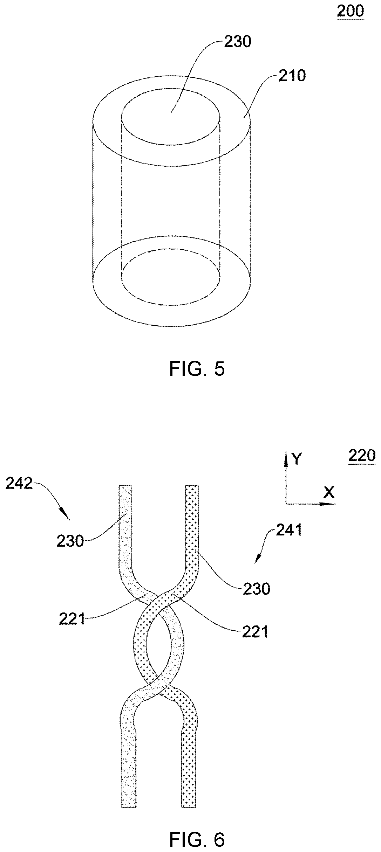

Referring to FIG. 5, it is a schematic structural diagram of a welding ribbon 200 shown in an embodiment of the present disclosure. FIG. 5 is an embodiment based on FIGS. 3 and 4. The welding ribbon 200 comprises a welding core 230 made of metal material with excellent electrical conductivity and a coating 210 that facilitates welding. The welding core 230 is in number of one, and the coating 210 is wrapped around the single welding core 230.

The welding ribbon 200 may be a flat tin-coated copper tape or a round tin-coated copper tape. The welding core 230 is of a cylindrical linear structure, and the material of the welding core 230 is copper. The welding core 230 may be a round thin copper wire of 0.25-0.35 mm. The welding core 230 may be formed by continuously extruding and thinning a relatively thick copper column or copper strip through a wire drawing mechanism. In the process of forming the fine copper wire, the copper metal is subjected to strong extrusion stress, so that after the extrusion is completed, the stress will be eliminated by high-temperature heating of the furnace tube or high-temperature heating of high current and annealing.

The material of the coating 210 is tin, tin alloy or tin-lead alloy, and the coating 210 can be formed by making the welding core 230 pass through the molten liquid of tin, tin alloy or tin-lead alloy.

When the battery sheet 300 is a battery sheet 300 with 6 busbars (6BB), the welding ribbon 200 comprises a flat welding core 230 with a width of 1 mm and thickness of 0.25 mm, and a coating 210 with thickness of about 15 µm. When the battery sheet 300 is a battery sheet 300 of multi-busbar technology, such as, 9 busbars (9BB), 10 busbars (10BB), or 12 busbars (12BB), etc., the welding ribbon 200 comprises a circular welding core 230 with diameter of about 0.3 mm, and a coating 210 with thickness of about 15um.

Referring to FIG. 6, it is a schematic structural diagram of a composite core 220 according to an embodiment of the present disclosure. FIG. 6 is an embodiment based on FIGS. 3 and 4. The welding ribbon 200 comprises a composite core 220, the composite core 220 comprises a plurality of welding cores 230, each of the welding cores 230 is provided with at least one first bending part 221, and the plural welding cores 230 are wound with each other through the respective first bending parts 221 to from the composite core 220.

Here, the individual welding cores 230 may be the same or different in length, diameter and other dimensions. The radial cross section of the welding core 230 is circular, elliptical, rectangular, square, trapezoidal or triangular. The material of the welding core 230 is metal, such as copper or steel, etc. In this embodiment, the radial cross section of the welding core 230 is circular, and the material of the welding core 230 is copper.

The plurality of cores 230 are arranged in two welding core groups, with each welding core group including one core 230. The two welding core groups are the first welding core group 241 and the second welding core group 242 respectively. The first welding core group 241 passes through the first bending parts 221 of the second welding core group 242, and the second welding core group 242 passes through the first bending parts 221 of the first welding core group 241. The first welding core group 241 and the second welding core group 242 are rotatably wound (intertwined) with each other, so as to form a composite core 220 in shape of a twisted pair.

Herein, the bending direction of the first bending part 221 is the X direction, and is arranged as perpendicular to the length direction (i.e., the Y direction) of the welding core 230.

In an operation process, two identical welding cores 230 (with the diameter of 0.15mm, in form of metal cylinder) are obtained, and every two of them are wound with each other in the same manner as in FIG. 6, to form a composite core 220 (with diameter of 0.3mm) in shape of a twisted pair.

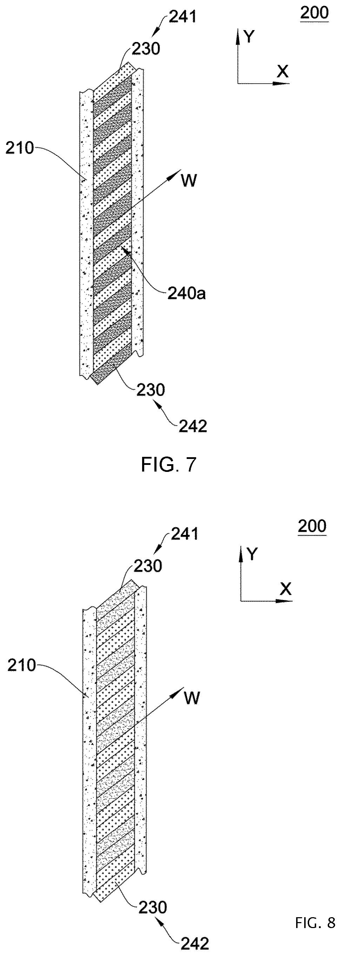

Referring to FIG. 7, it is a schematic diagram of the internal structure of the welding ribbon 200 according to an embodiment of the present disclosure. FIG. 7 can be obtained by making variation on the basis of FIG. 6. Two identical welding cores 230 are obtained, and the two welding cores 230 are divided into a first welding core group 241 and a second welding core group 242, every two of which are wound with each other in a manner similar to that in FIG 6; and they are strained to enable the welding cores 230 to be interlocked with each other, so as to form the composite core 220 in a threadlike shape.

Herein, the bending direction of the first bending part 221 is the W direction, and is disposed obliquely with respect to the length direction (i.e., the Y direction) of the welding core 230.

An interface 240a exists at the junction between the first welding core group 241 and the second welding core group 242. When a laser pointer is used to irradiate laser light on the surface of the composite core 220, the interface 240a has an effect similar to the light reflective welding ribbon 200. The interface 240a can effectively reflect the light to the front surface 300a or the back surface 300b of the battery sheet 300 next to the welding ribbon 200, so that the shading loss can be reduced, the shading effect of the metal welding ribbon 200 can be reduced, and the power generation efficiency of the solar cell assembly 100 can be improved.

The welding ribbon 200 further comprises a coating 210, and the coating 210 is wrapped around the composite core 220. The coating 210 is provided outside the composite core 220, and the external structure of the welding ribbon 200 may be of a straight line type, or a bending part may be additionally provided. In this embodiment, the outer structure of the welding ribbon 200 is the straight line type.

The material of the coating 210 is a low-temperature welding material, such as, tin (Sn), bismuth (Bi), lead (Pb), and indium (In), etc., or alloys of tin, bismuth, lead, and indium, or alloys of tin, bismuth, lead, indium, and other metals. In this embodiment, the material of the coating 210 is tin or tin alloy.

During an operation process, the composite core 220 is coated with the coating 210 by electroplating, or by thermal soaking.

In an operation process, a coating 210 of about 10-15um is additionally coated to the composite core 220 by electroplating. The material of the coating 210 is tin-containing metal, and the light reflection effect of the interface 240a (referring to FIG. 7) will be further enhanced.

In an operation process, the composite core 220, through being firstly subjected to the high temperature annealing treatment and then the electroplating treatment or thermal soaking (infiltration), is coated with the coating 210. After the composite core 220 is annealed at high temperature, the stress can be eliminated, so that the structure of the composite core 220 is more stable.

The following table is a list of linear thermal expansion coefficients of commonly used materials for photovoltaic assemblies.

| Materials | Linear thermal expansion coefficients (10^-6 mm/mm°C, i.e., 10^-6 /°C) |
|---|---|
| Cu | 17 |
| Sn | 2 |
| Si | 2.5 |
| Pb | 28 |
| PbSnCu | 1.7 |
| Al | 23 |
| Ag | 19 |
| EVA | 180 |
| PET | 59 |
| Optical glass | 7 |

The material of the battery sheet 300 is silicon, the material of the welding core 230 and the composite core 220 in the welding ribbon 200 is copper, and the influence of the coating 210 in the welding ribbon 200 is small and can be ignored. The thermal expansion performances of the battery sheet 300 and the welding ribbon 200 are very different. In the vicinity of the temperature range of 20-200°C, the linear thermal expansion coefficient of copper is 17×10^-6 /°C, and the linear thermal expansion coefficient of silicon is 2.5×10^-6 /°C. The thermal expansion coefficients of the welding ribbon 200 and the battery sheet 300 differs by a factor of 7, wherein length variation of the corresponding component = linear thermal expansion coefficient × temperature variation × material length.

Referring to FIG. 5, FIG. 3 and FIG. 4, assuming that a silicon wafer in a square structure, with a side length of 210mm is cut into two battery sheets 300, and the welding length of the battery sheets 300 is 100 mm, that is, the material length of the welding ribbon 200 is equal to the welding length of the battery sheet 300, calculated as 100mm. At room temperature and a welding temperature of 200°C, the length variation of the welding ribbon 200 is 0.34 mm. The length variation of the battery sheet 300 is about one-seventh of that of the welding ribbon 200, and the difference between the length variations of the two is about 0.29 mm.

If in order to increase the production capacity, when the welding temperature is made to reach 280°C and the welding length of the battery sheet 300 is 158 mm, that is, when the welding ribbon 200 is calculated as 158 mm, the length variation of the welding ribbon 200 can reach 0.75 mm. However, the length variation of the battery sheet 300 is still only about one-seventh of that of the welding ribbon 200, and the difference between the length variations of the two is about 0.64 mm. As a result, a strong stress is easily generated between the battery sheet 300 and the welding ribbon 200, so that debris (fragments) is easily formed, or cracks are formed inside the battery sheet 300.

Referring to FIG. 7, FIG. 3 and FIG. 4, since the welding core 230 has the first bending part 221, the bending direction (W direction) of the first bending part 221 is arranged as oblique relative to the length direction (Y direction) of the welding core 230, the extending direction of the welding core 230 in the welding ribbon 200 has components in two directions of X and Y, thereby forming an oblique winding direction. Therefore, when expanding or contracting in cold and heat, the expansion or contraction direction of the welding core 230 in the welding ribbon 200 comprises components in two directions of X and Y. The X-direction component is a buffer zone where stress can be released, so that the mechanical stress inside the solar cell assembly 100 can be reduced or partially eliminated.

Therefore, the embodiment shown in FIG. 7 is under the same conditions as the embodiment shown in FIG. 5, when calculating the length variations of the battery sheet 300 and the welding ribbon 200, the calculation of the material length of the welding ribbon 200 only needs the component in the Y direction, and the component in the X direction is not needed to be calculated. Therefore, the effective material length of the welding ribbon 200 becomes smaller, while the material length of the battery sheet 300 remains unchanged, so that the length variation of the welding ribbon 200 becomes smaller, the length variation of the battery sheet 300 remains unchanged, and the difference between the length variation of the welding ribbon 200 and the length variation of the battery sheet 300 is reduced and it is no longer a one-seventh ratio.

Therefore, in this embodiment, the stress between the welding ribbon 200 and the battery sheet 300 is buffered by the first bending part 221 on each welding core 230 in the composite core 220, thereby reducing the probability that debris appears or the battery sheet 300 is cracked therein, which can increase the yield rate, and also help to improve the power generation and reliability of the solar cell assembly 100.

During an operation process, the magnitude of the component in the X direction is adjusted by adjusting the bending direction (W direction) of the first bending part 221, thereby adjusting the magnitude of the buffer stress.

Referring to FIG. 8, it is a schematic diagram of the internal structure of the welding ribbon 200 according to an embodiment of the present disclosure. FIG. 8 is an embodiment based on the embodiment shown in FIG. 7. The first welding core group 241 comprises two welding cores 230 arranged side by side; and the second welding core group 242 comprises two welding cores 230 arranged side by side.

In one embodiment, each welding core group comprises a plurality of welding cores 230, and the plural welding cores 230 are wound (intertwined) with each other to form a thread shape, a twisted pair shape, a sailor knot shape or a Chinese knot shape.

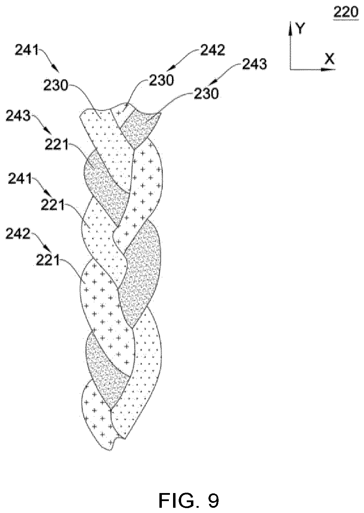

Referring to FIG. 9, it is a schematic structural diagram of a composite core 220 according to an embodiment of the present disclosure. FIG. 9 is an embodiment based on the embodiment shown in FIG. 7. The plurality of welding cores 230 are divided into three welding core groups, and the three welding core groups are wound and braided with each other, to form a composite core 220 in a braid shape. Each welding core group comprises one welding core 230. The three welding core groups are a first welding core group 241, a second welding core group 242 and a third welding core group 243 respectively.

During an operation process, the first welding core group 241 passes through the first bending part 221 of the second welding core group 242, the second welding core group 242 passes through the first bending part 221 of the third welding core group 243, the third welding core group 243 then passes through the first bending part 221 of the first welding core group 241. They are wound repeatedly, so that the first welding core group 241, the second welding core group 242 and the third welding core group 243 are wound and braided (woven), so as to form the composite core 220 in the braid shape.

In one embodiment, each welding core group comprises a plurality of welding cores 230, and the plural welding cores 230 are arranged side by side (parallel with each other).

In one embodiment, each welding core group comprises a plurality of welding cores 230, and the plural welding cores 230 are wound with each other to form a thread shape or a twisted pair shape.

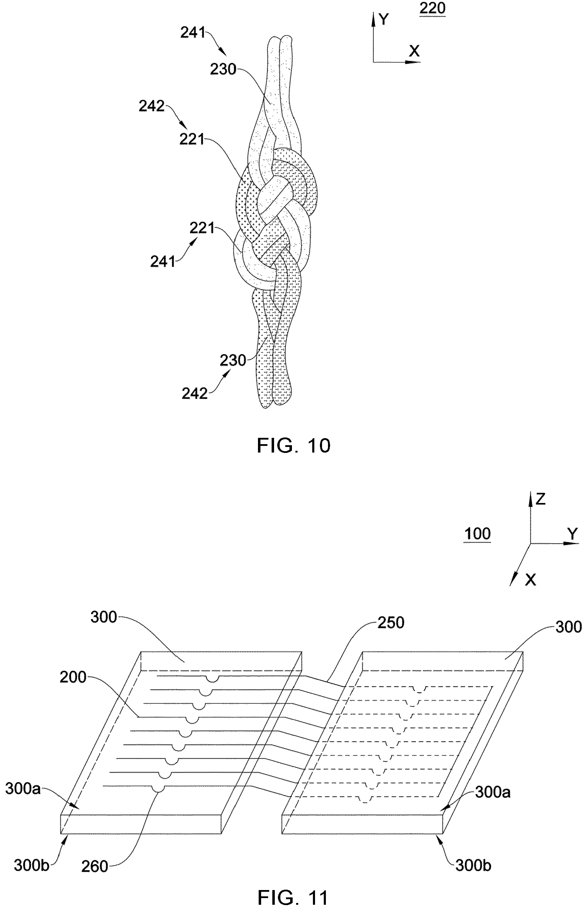

Referring to FIG. 10, it is a schematic structural diagram of a composite core 220 according to an embodiment of the present disclosure. FIG. 10 is an embodiment based on the embodiment shown in FIG. 7. The plurality of welding cores 230 are arranged in two welding core groups 230, each of which has one welding core 230. The two welding core groups are respectively a first welding core group 241 and a second welding core group 242. The first welding core group 241 and the second welding core group 242 are wound and woven with each other to form a composite core 220 in a sailor knot shape.

In an operation process, the first welding core group 241 is first folded in half, and then the first welding core group 241 is bent to form the first bending part 221, so that the first welding core group 241 is of an "α" shape as a whole. Next, the second welding core group 242 is folded in half, and then the second welding core group 242 is bent to form the first bending part 221, so that the second welding core group 242 is of an "α" shape as a whole, and then the first welding core group 241 is made to pass through the first bending part 221 of the second welding core group 242, the second welding core group 242 is made to pass through the first bending part 221 of the first welding core group 241, and after tensioning, the first welding core group 241 and the second welding core group 242 are wound and woven with each other to form a composite core 220 in the sailor knot shape.

In one embodiment, each welding core group comprises a plurality of welding cores 230, and the plural welding cores 230 are arranged side by side.

In one embodiment, each welding core group comprises a plurality of welding cores 230, and the plural welding cores 230 are wound with each other to form a thread shape or a twisted pair shape.

In one embodiment, the first welding core group 241 and the second welding core group 242 are wound and braided with each other to form the composite core 220 in the Chinese knot shape.

In the embodiment of the present disclosure, the stress between the buffer welding ribbon and the battery sheet can be realized by at least one third bending part additionally provided on the welding ribbon, in addition to the first bending part of the composite welding core. The embodiment of solar cell assembly, using the welding ribbon of the present disclosure including at least one third bending part, is provided below.

Referring to FIG. 11, it is a schematic structural diagram of a solar cell assembly 100 according to an embodiment of the present disclosure. The welding ribbon 200 may be any of the embodiments shown in FIG. 6 to FIG. 10, or may be the embodiment shown in FIG. 5. Each welding ribbon 200 is provided with at least one third bending part 260, and the at least one third bending part 260 is closely attached to the middle portion of the corresponding battery sheet 300, wherein the middle portion of the battery sheet 300 refers to the non-edge location (portion) of the battery sheet 300.

The bending direction of the third bending part 260 is the X direction, which is arranged as perpendicular to the bending direction (Z direction) of the second bending part 250, and perpendicular to the length direction (Y direction) of the welding core 230. In the present embodiment, the bending direction of the third bending part 260 is parallel to the surface (i.e., the front surface 300a and the back surface 300b) of the corresponding battery sheet (i.e., the battery sheet 300).

Since the welding ribbon 200 has the third bending part 260 and the bending direction (X direction) of the third bending part 260 is arranged as perpendicular to the length direction (Y direction) of the welding core 230, the extending direction of the welding core 230 inside the welding ribbon 200 has components in two directions of X and Y, and the third bending part 260 is the component in the X direction. Therefore, when expanding or contracting in heat or cold, the expansion or contraction direction of the welding core 230 in the welding ribbon 200 comprises the components of two directions of X and Y. The X-direction component (the third bending part 260) is one buffer zone where the stress can be released, that is, the stress is no longer accumulated in the third bending part 260.

Therefore, the embodiment shown in FIG. 11 is under the same conditions as the embodiment shown in FIG. 5, wherein when calculating the length variations of the battery sheet 300 and the welding ribbon 200, the calculation of the material length of the welding ribbon 200 requires that the length of the third bending part 260 along the Y direction is subtracted, so the effective material length of the welding ribbon 200 becomes smaller, while the material length of the battery sheet 300 remains unchanged, so that the length variation of the welding ribbon 200 becomes smaller, and the length variation of the battery sheet 300 remains unchanged. The difference between the length variation of the welding ribbon 200 and the length variation of the battery sheet 300 is reduced, and it is no longer a ratio of one-seventh.

It should be noted that the stress elimination should be solved from the middle portion of the battery sheet 300. If the third bending part 260 is provided at the edge of the battery sheet 300, the reduction value of the effective material length of the welding ribbon 200 is relatively small, and then the effect on the length variation of the welding ribbon 200 is relatively small.

That is, when the welding ribbon 200 is provided with a plurality of third bending parts 260, the third bending parts 260 may all be located at the non-edge positions of the battery sheet 300, that is, the middle position of the welding ribbon 200, or may be located partially at the non-edge positions of the battery sheet 300 and partially at the edge positions of the battery sheet 300. Only the third bending parts 260 provided at the non-edge positions of the battery sheet 300 can change the effective material length of the welding ribbon 200 to a large extent, and affect the length variation of the welding ribbon 200, so that the stress is no longer accumulated.

For example, if in the embodiment of FIG. 5, the length variation of the welding ribbon 200 is 0.3 mm, when the third bending part 260 is arranged at the edge position of the battery sheet 300, that is, at the end of the welding ribbon 200, the length variation of the welding ribbon 200 is about 0.29 mm, which is close to 0.3 mm, and the effect of releasing the stress is relatively low. When one third bending part 260 is provided at a non-edge position of the battery sheet 300, that is, at a middle position of the welding ribbon 200, the length variation of the welding ribbon 200 is 0.15 mm, and the effect of eliminating the stress is better. When four third bending parts 260 are located at the non-edge positions of the battery sheet 300, that is, the middle position of the welding ribbon 200, the length variation of the welding ribbon 200 is 0.075 mm, enabling better stress eliminating effect.

Therefore, in this embodiment, the stress between the welding ribbon 200 and the battery sheet 300 is buffered by the third bending parts 260 additionally provided on the welding ribbon 200, thereby reducing the probability that debris appears or cracks are formed in the interior of the battery sheet 300, increasing the yield rate and also improving the power generation and reliability of the solar cell assembly 100.

In another embodiment, the welding ribbon of the solar cell assembly 100 is a composite welding ribbon, and the composite welding ribbon comprises a plurality of welding ribbons 200, wherein each of the welding ribbons 200 (called as a single welding ribbon) comprises a single welding core 230 and a coating 210 which is wrapped outside the single welding core 230. The single welding ribbon 200 is provided with a third bending part 260. A plurality of welding ribbons 200 are wound with each other through the respective third bending parts 260 to form a composite welding ribbon. The composite welding ribbon may be of a structure similar to the composite core 220 shown in FIGS. 6-10, i.e., a thread shape, a twisted pair shape, a sailor knot shape, a braid shape, or a Chinese knot shape.

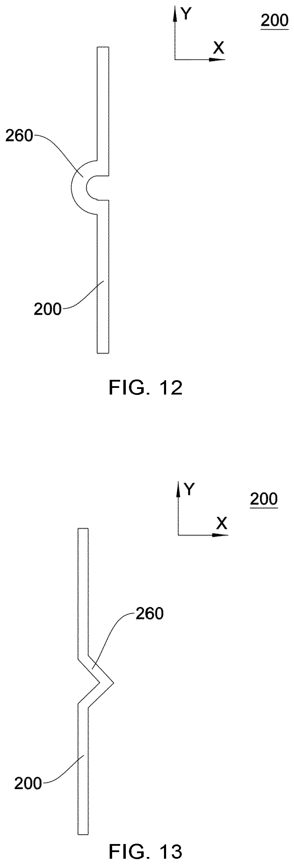

Referring to FIG. 12, it is a schematic structural diagram of a welding ribbon 200 according to an embodiment of the present disclosure. One third bending part 260, which is of a circular structure, is provided. Here, the welding ribbon 200 may be the embodiment shown in any of FIG. 6 to FIG. 10, or may be the embodiment shown in FIG. 5.

The third bending part 260 may be formed by bending the welding ribbon 200 along the X direction (referring to the direction parallel to the front surface 300a of the battery sheet 300 in FIG. 11) through one mechanical extrusion molding mechanism. The forming of the third bending part 260 may be performed before the welding ribbon 200 is fixed to the battery sheet 300, that is, before the series welding of the battery sheets 300.

Referring to FIG. 13, it is a schematic structural diagram of a welding ribbon 200 according to an embodiment of the present disclosure. One third bending part 260, which is of a triangular structure, is provided. Here, the welding ribbon 200 may be the embodiment shown in any of FIG. 6 to FIG. 10, or may be the embodiment shown in FIG. 5.

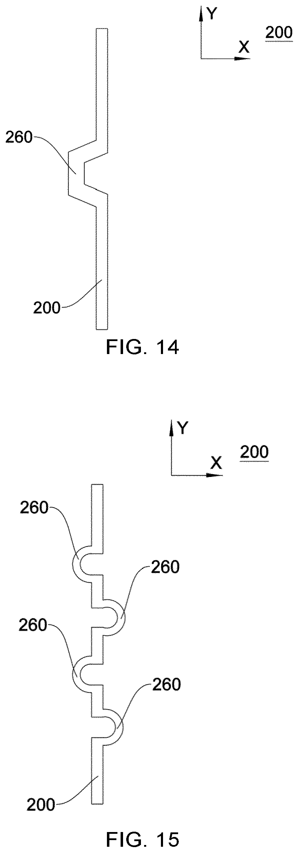

Referring to FIG. 14, it is a schematic structural diagram of a welding ribbon 200 according to an embodiment of the present disclosure. One third bending part 260, which is of a trapezoidal structure, is provided. Here, the welding ribbon 200 may be the embodiment shown in any of FIG. 6 to FIG. 10, or may be the embodiment shown in FIG. 5.

Referring to FIG. 15, it is a schematic structural diagram of a welding ribbon 200 according to an embodiment of the present disclosure. A plurality of third bending parts 260 are provided, and they are of a circular structure. The plurality of third bending parts 260 are arranged at intervals. Here, the welding ribbon 200 may be the embodiment shown in any of FIG. 6 to FIG. 10, or may be the embodiment shown in FIG. 5.

In this embodiment, four third bending parts 260 are provided, wherein the bending directions of two third bending parts 260 are the negative direction of the X axis, and the bending directions of two third bending parts 260 are the positive direction of the X axis. In another embodiment, there are four or more third bending parts 260, which are of a triangular structure, a square structure or a trapezoidal structure. In addition, the plurality of third bending parts 260 may be arranged such that the intervals between every two adjacent third bending parts 260 are equal. The bending directions of the plurality of third bending parts 260 may also be provided as same as the negative direction of the X axis or the positive direction of the X axis.

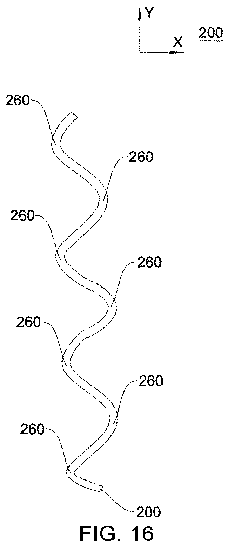

Referring to FIG. 16, it is a schematic structural diagram of a welding ribbon 200 according to an embodiment of the present disclosure. A plurality of third bending parts 260, which are of a wave-shaped structure, are provided. The plurality of third bending parts 260 are continuously arranged. Here, the welding ribbon 200 may be the embodiment shown in any of FIG. 6 to FIG. 10, or may be the embodiment shown in FIG. 5.

In this embodiment, there are seven third bending parts 260, wherein the bending directions of four third bending parts 260 are the negative direction of the X axis, and the bending directions of three third bending parts 260 are the positive direction of the X axis. The length of the welding ribbon 200 is 80 mm. In the wave bending design of the third bending parts 260, the width of the wave crest along the X direction is 10 µm.

In this embodiment, the third bending parts 260 are provided on the whole of the welding ribbon 200. When the welding ribbon 200 is in contact with the battery sheet 300, the third bending parts 260 are provided partially at the non-edge positions of the battery sheet 300, and partially at the edge positions of the battery sheet 300.

The welding ribbon 200 is slightly bent during the manufacturing process. During one operation process, firstly, a cylindrical copper wire with a length of 140-220 mm, a plum blossom-shaped hard roller with a corrugation depth of 10 um, and a rubber soft roller are provided, wherein the cylindrical copper wire is made to roll, passing-through between the two rollers, and the cylindrical copper wire is formed, through the rolling, into a wavy copper wire with a uniform 10um wave, and then tin is coated to the surface of the wavy copper wire to form the welding ribbon 200 of this embodiment. In this embodiment, the manufacturing is simple, and the stress accumulation is eliminated without affecting the welding.

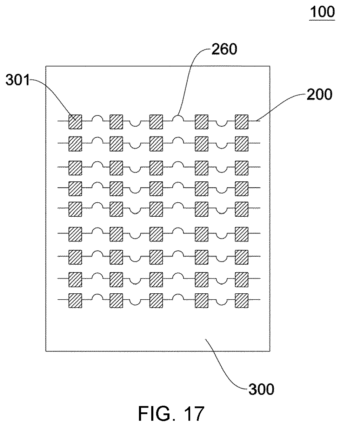

Referring to FIG. 17, it is a schematic diagram of a partial structure of a solar cell assembly 100 according to an embodiment of the present disclosure. The gate lines on the front surface 300a and the back surface 300b (referring to FIG. 11) of the battery sheet 300 are generally made of metal material, which may be silver (Ag) or aluminum (Al) alloy (such as, silver paste gate lines, aluminum paste gate lines, silver aluminum paste gate lines, etc., formed by screen printing and sintering), or the copper alloy (such as, NiCuSn alloy, that is, nickel copper tin alloy, formed by electroplating process). The welding ribbons 200 are arranged on the gate lines of the corresponding battery sheet 300. The battery sheet 300 is a battery sheet of 9 busbar (9BB) multi-barbar technology.

In order to enhance the welding strength of the welding ribbon 200 and the metal electrodes on the surface of the battery sheet 300, the gate lines of the battery sheet 300 is provided with welded reinforcing blocks 301, which are plural and can be uniformly or non-uniformly distributed on the main gate lines of the battery sheet 300.

In this embodiment, there are five reinforcing blocks 301 provided on one main gate line, and each of the third bending parts on one welding ribbon 200 is located between two adjacent reinforcing blocks 301.

The present disclosure also provides following several embodiments of solar cell assemblies using the welding ribbons of the present disclosure.

Embodiment 1: in this embodiment, each welding ribbon on the surface of the corresponding battery sheet for the solar cell assembly is provided with 4 third bending parts of the circular structure, to form 4 circular stress releasing buffer zones, which particularly includes the follows.
1. first, cutting, in half, 72 square finished battery sheets, with side length of 158.75mm in 9-busbar (9BB) electrode design, wherein, 5 welded reinforcing blocks are provided on each gate line on each surface (front surface and back surface) of each battery sheet, after the cutting in half;
2. placing, then, the first battery sheet onto the welding table of the stringer welding machine according to the preset position; and then, using a pulling mechanism to pull, onto the front surface of the first battery sheet, the cut 9BB circular welding ribbon of suitable size (including the welding core and the coating wrapped around the welding core);
3. using the molding mechanism, before or at the same time when the welding ribbon is pulled to the front surface of the first battery sheet, to bend the welding ribbon, through the mechanical squeezing/extrusion, along the thickness direction of the battery sheet (perpendicular to the front surface of the battery sheet), so as to form at least one second bending part, wherein the position of the bending is between the two battery sheets; and in addition, before the welding ribbon is pulled to the front surface of the first battery sheet, the welding ribbon is bent by the molding mechanism, through the mechanical squeezing/extrusion, along the direction perpendicular to the length direction of the welding core (and parallel to the front surface of the battery sheet) to form 4 third bending parts, wherein the bending positions are close to the middle portion of the first battery sheet and each third bending part is located between two adjacent reinforcing blocks; and at the same time, the welding ribbon is also bent by the molding mechanism, through the squeezing/extrusion manner, along the direction perpendicular to the length direction of the welding core (and parallel to the back surface of the battery sheet) to form 4 third bending parts, wherein the bending positions are close to the middle portion of the second battery sheet, and each third bending part is located between two adjacent reinforcing blocks;
4. placing, after the first battery sheet and the welding ribbon are put in place, the second battery sheet onto the welding ribbon, so that one end of the welding ribbon is connected to the front surface of the first battery sheet and the other end thereof is connected to the back surface of the second battery sheet, so as to form a series connection of the two battery sheets; and
5. repeating the above processes to complete the series connection of all battery sheets, and then performing the conventional processes, such as typesetting, lamination, and framing, etc., to form a finished solar cell assembly.

Embodiment 2: in this embodiment, one third bending part of a circular structure is provided on each welding ribbon on the surface of the corresponding battery sheet used in the solar cell assembly to form one circular stress releasing buffer zone, with the implementation method and steps being the same as those of Embodiment 1 above-mentioned.

Embodiment 3: in this embodiment, one third bending part of a pointed structure is provided on each welding ribbon on the surface of the corresponding battery sheet used in the solar cell assembly, to form a pointed stress releasing buffer zone, with the implementation method and steps being the same as those of Embodiment 1 above-mentioned.

Embodiment 4: in this embodiment, 4 third bending parts of a pointed structure are provided on each welding ribbon on the surface of the corresponding battery sheet used in the solar cell assembly, to form 4 pointed stress releasing buffer zones, with the implementation method and steps being the same as those of Embodiment 1 above-mentioned.

Embodiment 5: in this embodiment, one third bending part of a trapezoidal structure is provided on each welding ribbon on the surface of the corresponding battery sheet used in the solar cell assembly to form one trapezoidal stress releasing buffer zone, with the implementation method and steps being the same as those of Embodiment 1 above-mentioned.

Embodiment 6: In this embodiment, 4 third bending parts of a trapezoid structure are provided on each welding ribbon on the surface of the corresponding battery sheet used in the solar cell assembly, to form 4 trapezoidal stress releasing buffer zones, with the implementation method and steps being the same as those of Embodiment 1 above-mentioned.

It should be noted that, in the case of no conflict, those skilled in the art can arbitrarily select and combine the shape and quantity of the third bending parts provided on the welding ribbon for the solar cells on the basis of the above embodiments.

The welding ribbons in the above-mentioned Embodiments 1 to 6 may be a welding ribbon which has a single welding core (e.g., as shown in FIG. 5), or may be a welding ribbon which has a composite core structure (e.g., as shown in any of FIGS. 6 to 10 ), (i.e., plural welding cores). The plurality of welding cores are wound with each other through the respective first bending parts, that is, the welding ribbon forms a component on the surface of the solar cell, with the component at an angle with respect to the extension direction of the welding ribbon, and this component is also a very good stress releasing buffer zone, wherein the size of the component can be adjusted by adjusting the manufacturing process of the composite core.

In addition, for the case where the solar cell assembly has the welding ribbon of the composite core structure, the present disclosure also provides the following seventh embodiment, including:
1. cutting in half, firstly, 72 square finished battery sheets with a side length of 158.75mm, of a 9-busbar (9BB) electrode design;
2. placing, then, the first battery sheet onto the welding table of the stringer welding machine according to the preset position; and then, using a pulling mechanism to pull, onto the front surface of the first battery sheet, the cut 9BB circular welding ribbon of suitable size (including the composite core and the coating wrapped around the composite core);
3. using the molding mechanism, before or at the same time when the welding ribbon is pulled to the front surface of the first battery sheet, to bend the welding ribbon, through the mechanical squeezing, along the thickness direction of the battery sheet (perpendicular to the front surface of the battery sheet), so as to form at least one second bending part, wherein the position of the bending is between the two battery sheets;
4. placing, after the first battery sheet and the welding ribbon are put in place, the second battery sheet onto the welding ribbon, so that one end of the welding ribbon is connected to the front surface of the first battery sheet and the other end thereof is connected to the back surface of the second battery sheet, so as to form a series connection of the two battery sheets; and
5. repeating the above processes to complete the series connection of all battery sheets, and then performing the conventional processes, such as typesetting, lamination, and framing, etc., to form a finished solar cell assembly.

The welding ribbon and the solar cell assembly including the welding ribbon, which are provided by the present disclosure, can reduce or even eliminate the thermal stress between the welding ribbon and the battery sheet; reduce other mechanical stress of the solar cell assembly in the manufacturing process, and help to comprehensively reduce the problems of debris and cracking. The composite welding ribbon provided by the present disclosure can also reduce the light shading effect of the welding ribbon, and improve the power generation of the solar cell assembly.

The present disclosure also provides the following several technical solutions to solve the problems caused by thermal expansion stress between the welding ribbon 200 and the battery sheet 300.
1. the welding temperature during the string welding process of battery sheets 300 of the assembly is reduced, which may however affect the productivity and increase the difficulty of process control, and it is still impossible to completely avoid the strong stress between the welding ribbon 200 and the battery sheet 300.
2. a part of the current collecting capacity is lost, and the welding length of the welding ribbon 200 is shortened, which may however lose the assembly power and increase the cost per watt, and cannot completely avoid the strong stress between the welding ribbon 200 and the battery sheet 300.
3. a part of the light-receiving area on the surface of the battery sheet 300 is lost, the thickness of the welding ribbon 200 is reduced and the width of the welding ribbon 200 is increased, which may however lose the power of the solar cell assembly 100 and increase the cost per watt, and cannot completely avoid the strong stress between the welding ribbon 200 and the battery sheet 300.
4. the welding ribbon 200 is removed, and the technical solution of directly connecting the edges of the battery sheets 300 is adopted. However, this technical solution requires that the conduction distance of the current is very short. Therefore, generally, the battery sheet 300 needs to be cut into 5-6 small pieces. Even so, the effective conduction distance of 6 small pieces is only comparable to that of conventional 3-busbar (3BB) batteries. The effective conductive distance of this technical solution is relatively small, and they are needed to be cut for more times, and the consumption of silver paste of the battery is greatly increased compared with the conventional 9-busbar (9BB) battery, and the cost is higher.

Only preferred embodiments of the present disclosure are described above, and are not intended to limit the present disclosure. For those skilled in the art, the present disclosure may have various modifications and changes. Any modifications, equivalent replacements, improvements, etc., made within the spirit and principle of the present disclosure, shall be covered by the protection scope of the present disclosure.

### Industrial Applicability

The welding ribbon and the solar cell assembly including the welding ribbon provided by the present disclosure can reduce or even eliminate the thermal stress between the welding ribbon and the battery sheet; and reduce other mechanical stress of the solar cell assembly in the manufacturing process, which is helpful for comprehensively reducing the problems of debris and cracking. The composite welding ribbon provided by the present disclosure can also reduce the light shading effect of the welding ribbon and improve the power generation of the solar cell assembly.

Furthermore, it will be appreciated that the welding ribbon of the present disclosure and the solar cell assembly including the welding ribbons are reproducible and can be used in any applications which need to utilize the solar energy.

## Claims

1. A welding ribbon, comprising:
a composite core, comprising a plurality of welding cores, wherein each of the welding cores is provided with at least one first bending part, and the plurality of welding cores are wound with each other through the respective first bending parts to form the composite core; and
a coating, which is wrapped outside the composite core.

2. The welding ribbon according to claim 1, wherein the plurality of the welding cores are divided into a plurality of welding core groups, and each of the welding core groups comprises one or more welding cores, and
the plurality of the welding core groups are wound with each other to form the composite core.

3. The welding ribbon according to claim 2, wherein each of the welding core groups comprises a plurality of the welding cores; and
in each of the welding core groups, the plurality of welding cores are arranged side by side or the plurality of the welding cores are wound with each other.

4. The welding ribbon according to claim 2, wherein two welding core groups are provided, and the two welding core groups are wound with each other to form the composite core in shape of a thread, a twisted pair, or a sailor knot.

5. The welding ribbon according to claim 2, wherein three welding core groups are provided, and the three welding core groups are wound with each other to form the composite core in shape of a braid.

6. The welding ribbon according to any one of claims 1 to 5, wherein a bending direction of the first bending parts is arranged as inclined relative to or perpendicular to a length direction of the welding cores.

7. The welding ribbon according to any one of claims 1 to 6, wherein a radial cross section of the welding cores is circular, elliptical, rectangular, square, trapezoidal or triangular.

8. The welding ribbon according to any one of claims 1 to 7, wherein the welding ribbon comprises at least one of following features:
the welding ribbon is formed in a way that the composite welding core, after being subjected to a high temperature annealing treatment, is wrapped with the coating;
a material of the coating is tin, bismuth, lead, indium, tin alloy, bismuth alloy, lead alloy or indium alloy;
the coating is formed by electroplating or hot dipping;
a material of the welding cores is copper or steel; and
individual welding cores have same lengths and same diameters.

9. A welding ribbon, comprising:
a single welding core and a coating wrapped around the single welding core; and
at least one third bending part, which is provided on the welding ribbon, wherein a bending direction of the at least one third bending part is arranged as perpendicular to a length direction of the single welding core.

10. The welding ribbon according to claim 9, wherein,
a bending direction of the at least one third bending part is parallel to a surface of a corresponding battery sheet; and
preferably, the third bending part is of a structure which is one of following:
a circular structure, a triangular structure, a trapezoidal structure, a square structure or a wave-shaped structure.

11. A solar cell assembly, comprising:
a plurality of welding ribbons, each of which is the welding ribbon according to any one of claims 1 to 8; and
a plurality of battery sheets, which are connected by the plurality of the welding ribbons,
wherein each of the plurality of welding ribbons is provided with at least one second bending part, and the second bending part is provided between two adjacent battery sheets; and a bending direction of the second bending part is a thickness direction of the battery sheets.

12. The solar cell assembly according to claim 11, wherein each of the welding ribbons is provided with at least one third bending part, and the at least one third bending part is closely attached to a middle portion of a corresponding battery sheet, and a bending direction of the at least one third bending part is arranged as perpendicular to a length direction of the welding cores;
preferably, a bending direction of the at least one third bending part is parallel to a surface of a corresponding battery sheet; and
preferably, the third bending part is of a structure which is one of following:
a circular structure, a triangular structure, a trapezoidal structure, a square structure or a wave-shaped structure.

13. The solar cell assembly according to claim 12, comprising:
a plurality of reinforcing blocks, which are arranged on gate lines of the battery sheet,
wherein the welding ribbons are arranged on the gate lines of the corresponding battery sheets, and each of the third bending parts is located between two adjacent reinforcing blocks;
preferably, the gate lines are in number of 9, 10 or 12;
preferably, the reinforcing blocks are evenly distributed on the gate lines and intervals between adjacent third bending parts are equal; and
preferably, on each of the gate lines of the corresponding battery sheet, the reinforcing blocks are in number of 5.

14. A solar cell assembly, comprising:
a plurality of welding ribbons, each of the welding ribbons comprises a welding core and a coating wrapped around the welding core; and
a plurality of battery sheets, which are connected through the plurality of the welding ribbons,
wherein each of the welding ribbons is provided with at least one second bending part and at least one third bending part, and the second bending part is provided between two adjacent battery sheets, and the at least one third bending part is tightly attached to a middle portion of the corresponding battery sheet;
a bending direction of the second bending parts is a thickness direction of the battery sheets, and a bending direction of the third bending parts is arranged as perpendicular to a length direction of the welding cores.

15. The solar cell assembly according to claim 14, wherein the welding core is a single welding core;
preferably, the single welding core is of a cylindrical linear structure; and
preferably, the single welding core is a round thin copper wire of 0.25 mm to 0.35 mm.

16. The solar cell assembly according to claim 14 or 15, wherein a bending direction of the third bending part is parallel to a surface of the corresponding battery sheet; and
preferably, the third bending part is of a structure which is one of following:
a circular structure, a triangular structure, a trapezoidal structure, a square structure or a wave-shaped structure.

17. The solar cell assembly according to claim 15, wherein the plurality of the welding ribbons form a composite welding ribbon by being wound with each other through respective third bending parts thereof; and preferably, the composite welding ribbon is one of a thread shape, a twisted pair shape, a sailor knot shape, a braid shape, or a Chinese knot shape.

18. The solar cell assembly according to any one of claims 14 to 16, comprising:
a plurality of reinforcing blocks, which are arranged on gate lines of the battery sheet,
wherein the welding ribbon is arranged on the gate lines of the corresponding battery sheet, and each of the third bending parts is located between two adjacent reinforcing blocks;
preferably, the gate lines are in number of 9, 10 or 12;
preferably, the reinforcing blocks are evenly distributed on the gate lines and intervals between adjacent third bending parts are equal; and
preferably, on each of the gate lines of the corresponding battery sheet, the reinforcing blocks are in number of 5.
